Europäisches Patentamt

European Patent Office

Office européen des brevets

(19)

(11) Numéro de publication: **0 023 271**
**B1**

(12) **FASCICULE DE BREVET EUROPEEN**

(45) Date de publication du fascicule du brevet: **18.05.83**

(21) Numéro de dépôt: **80103548.6**

(22) Date de dépôt: **24.06.80**

(51) Int. Cl.³: **H 03 K  17/94,**
**H 03 K  13/24, G 06 F  3/023**

(54) **Clavier d'entrée de données à touches à impédance variable contrôlé par microprocesseur.**

(30) Priorité: **30.07.79 US  61719**

(43) Date de publication de la demande:
**04.02.81 Bulletin 81/5**

(45) Mention de la délivrance du brevet:
**18.05.83 Bulletin 83/20**

(84) Etats contractants désignés:
**BE CH DE FR GB LI NL SE**

(56) Documents cités:
**DE - A - 2 831 783**
**FR - A - 2 311 382**
**FR - A - 2 332 655**
**US - A - 3 437 795**
**US - A - 3 786 497**

**MICROPROCESSORS, vol. 2, no. 2, avril 1978
London GB MUNT: "Microprocessor keyboard
encoding", pages 67—70**

(73) Titulaire: **International Business Machines
Corporation
Armonk, N.Y. 10504 (US)**

(72) Inventeur: **Dahl, Jerome Paul
4821 Glen Forest Dr.
Raleigh, NC 27612 (US)**
Inventeur: **Epley, Phillip Russell
1714 Medfield Rd.
Raleigh, NC 27607 (US)**
Inventeur: **Fox, Jon Edward
1405 Laughridge D.
Raleigh, NC 27511 (US)**

(74) Mandataire: **Bonneau, Gérard
COMPAGNIE IBM FRANCE Département de
Propriété Industrielle
F-06610 La Gaude (FR)**

Courier Press, Leamington Spa, England.

# 0 023 271

Clavier d'entrée de données à touches à impédance variable contrôlé par microprocesseur

La présente invention concerne, de façon générale, les claviers électroniques à matrice de touches, et plus particulièrement, un clavier à touches à impédance variable contrôlé par un microprocesseur programmé pour fournir des niveaux de seuil de détection de l'enfoncement des touches tenant compte de l'impédance parasite pour chaque touche.

Il existe dans l'art antérieur de nombreux claviers à structure matricielle et à impédance variable tels que des claviers capacitifs et l'industrie fait largement appel à eux.

Dans ce type de clavier décrit dans les documents US—A—3 786 497, US—A—3 437 795, et FR—A—2 332 655 la capacitié entre les conducteurs de la matrice au point d'intersection où se trouve la touche, est modifiée à l'aide d'une plaque de couplage qui sert de couche diélectrique. A intervalles réguliers, une logique de détection procède au balayage des points d'intersection de la matrice par l'envoi d'un signal de détection. Lorsqu'une touche enfoncée vient à être balayée, le changement de capacité est détecté par un amplificateur de détection connecté à la colonne ou à la rangée dans laquelle se trouve la touche enfoncée.

Dans ce type de clavier, on rencontre toujours le même problème inhérent au fait que les changements de capacité sont très faibles et restent de l'ordre du pico-farad. Avec un si faible changement de capacité, les variations de la sensiblité de l'amplificateur, de la capacité parasite dans l'agencement des circuits et des conducteurs, et les effets que produisent de petities particules de poussière ou de contamination sur le substrat des circuits entre les bandes conductrices et la plaque de couplage capacitif, peuvent, entraîner une détection, ou une absence de détection, erronée de l'enfoncement des touches. Il apparaît vivement souhaitable que la détection qu'une touche a été actionnée ait lieu à environ la moitié du parcours séparant la position normalement ouverte de la position normalement fermée pour offrir la meilleure protection possible contre les effets de la capacité parasite et de la contamination.

Cependant, par suite des variations de la capacité parasite et de la sensibilité de l'amplificateur de détection, la détection peut se faire à plusieurs niveaux. Ceci signifie que la moindre poussière ou le moindre agent de contamination présent sur une touche particulière peut faire que la plaque de couplage se trouve trop écartée des bandes ou des contacts du substrat, en position normalement fermée. Ceci peut se traduire soit par une détection continue de la touche enfoncée soit par une absence de détection due à la trop faible valeur du changement de la capacité. En outre, la capacité parasite présente de façon inhérente dans les lignes conductrices des circuits impliqués, fournit un couplage capacitif qui est toujours présent si bien que l'effet net du changement de position de la touche lorsque celle-ci est actionnée peut devenir très faible en comparaison du signal présent de façon continue par suite des effets de couplage capacitif parasite.

Lorsqu'il est fait usage d'un amplificateur de détection ayant un seuil de sensibilité spécifique, l'effet de la capacité parasite doit s'ajouter à l'effet de la capacité de la touche c'est-à-dire que le signal détecté au niveau du seuil de l'amplificateur de détection est non seulement dû à la capacité parasite mais aussi à la capacité de la touche. En conséquence, pour un niveau de seuil efficace donné, la valeur de la variation de la capacité requise à partir de la position de la touche est la différence existant entre la capacité du seuil et la capacité du couplage parasite qui existe à cette position.

Pour éliminer les effets des divers niveaux de détection dus aux divers amplificateurs utilisés avec les différentes rangées ou colonnes de la matrice, et pour neutraliser les effets de la capacitié parasite, on a utilisé jusqu'ici divers réglages et diverses commandes de la sensibilité des amplificateurs et fait appel à des solutions relativement coûteuses. Cependant, toutes ces solutions ne sont pas favorables à une production en série de claviers bon marché, et fonctionnant à des vitesses élevées.

Le clavier de l'invention tel qu'il est caractérisé dans les revendications résout les problèmes ci-dessus en neutralisant les effets de la sensibilité de seuil variable dus aux fluctuations de la tension d'alimentation et aux tolérances des composants des amplificateurs de détection, ainsi que les effets de l'impédance parasite à chaque position de touche de la matrice de touches.

Pour obtenir ce résultat l'invention utilise un microprocesseur qui réalise les fonctions de balayage de la matrice de touches, de détection de l'enfoncement des touches et de décodage des signaux. L'utilisation d'un microprocesseur dans un clavier est d'ailleurs décrit dans l'article "Microprocessor Keyboard Encoding" de la revue "Microprocessors", Vol. 2, No. 2, d'avril 1978.

Le clavier d'entrée de données de l'invention comprend une matrice de touches à impédance variable correspondant respectivement aux intersections de rangées d'entrée et de colonnes de sortie, un microprocesseur programmé ayant au moins une entrée de signal et plusieurs sorties de signal, pour commander l'application de signaux d'attaque sur chacune desdites rangées, le microprocesseur étant programmé pour balayer séquentiellement les intersections de la matrice et fournir des signaux sur les colonnes de sortie de façon à déterminer si l'une quelconque des touches a changé d'état. Une impédance de référence fixe est placée à au moins une intersection de ladite matrice à laquelle n'est pas associée une touche à impédance variable pour connecter la rangée et la colonne se trouvant à cette intersection. Un circuit d'amplification à seuil variable est connecté à chacune des colonnes de sortie de la matrice et a pour fonction d'amplifier les signaux reçus sur la colonne de sortie

2

correspondante qui dépassent un seuil déterminé, la sortie du circuit d'amplification étant connectée à l'entrée du microprocesseur afin de fournir une indication qu'un signal dépassant le seuil a été détecté et amplifié par le circuit d'amplification. Ledit microprocesseur est programmé pour d'une part fournir au moins une fois un signal d'attaque à l'impédance de référence et pour fournir à nouveau un signal d'attaque à l'impédance de référence chaque fois qu'un signal en réponse au signal d'attaque de l'impédance de reference est reçu à l'entrée du microprocesseur à partir de la sortie du circuit d'amplification, et d'autre part pour fournir en sortie des signaux de seuil au circuit d'amplification à seuil variable pour initialement établir son seuil à un minimum, puis l'élever selon une gamme de niveaux croissants à chaque fois qu'un signal d'attaque de l'impédance de référence a donné lieu à un signal de réponse reçu à l'entrée du microprocesseur, de manière à déterminer un signal de seuil de base pour le circuit d'amplification. Le microprocesseur comprend une mémoire de données dans laquelle est emmagasiné un facteur d'impédance parasite associé à chaque position de touche identifiée à l'intersection d'une rangée et d'une colonne, le microprocesseur étant programmé pour avoir accès à l'emplacement de ladite mémoire de données associé à chacune des touches chaque fois que l'intersection correspondante de la matrice est balayée, de manière à modifier le signal de seuil de base en fonction du facteur d'impédance parasite associé à la touche et neutraliser ainsi les effets dûs à l'impédance parasite de la touche lors de son enfoncement.

Dans le mode de réalisation préféré, une routine de réglage du niveau de détection est utilisée, sous la commande du microprocesseur, pour que le circuit d'amplification soit correctement calibré à un niveau de commutation qui élimine effectivement les variations dues aux changements de la tension d'alimentation, aux variations de l'alimentation des transistors d'attaque, et aux autres tolérances des composants. Lorsqu'une position de touche donnée est addressée par le mécanisme de balayage des circuits du clavier, il y a accès à une table de valeurs emmagasinée dans une mémoire de manière à pouvoir connaître l'impédance parasite relative associée à cette position de touche, et le seuil du circuit d'amplification est soumis à variation pour régler l'implédance parasite. Par exemple, si une position de touche donnée a une impédance parasite élevée associée avec l'agencement spécifique du clavier dont elle fait partie, la sensibilité du circuit d'amplification est abaissée (c'est-à-dire, on va fixer un seuil de détection plus élevé). En revanche, si une faible impédance parasite est associée à la touche, la sensibilité du circuit d'amplification est accrue. La sensibilité est soumise à variation de sorte que la différence existant entre la sensibilité du seuil et l'impédance de couplage parasite soit constante et uniforme pour toutes les positions de touche du clavier.

Ainsi, les variations des paramètres du clavier sont efficacement compensées si bien que le seuil de détection électrique est atteint à une valeur nominale du déplacement de la touche, correspondant à la valeur physique du déplacement effectué par les dispositifs d'actionnement de la touche, ce qui fait qu'un point de commutation est atteint à la région centrale du parcours de chaque commutateur, point de commutation qui peut être considéré comme point optimal pour toutes les touches.

Un mode de réalisation de l'invention est décrit ci-dessous en référence aux dessins suivants:

La Figure 1 représente un diagramme de fonctionnement général d'un clavier matriciel à touches capacitives qui utilise une commande par micro-calculateur conforme aux caractéristiques de la présente invention.

La Figure 2 représente schématiquement les divers composants employés pour faire varier la sensibilité de l'amplificateur de détection sous la commande du micro-calculateur.

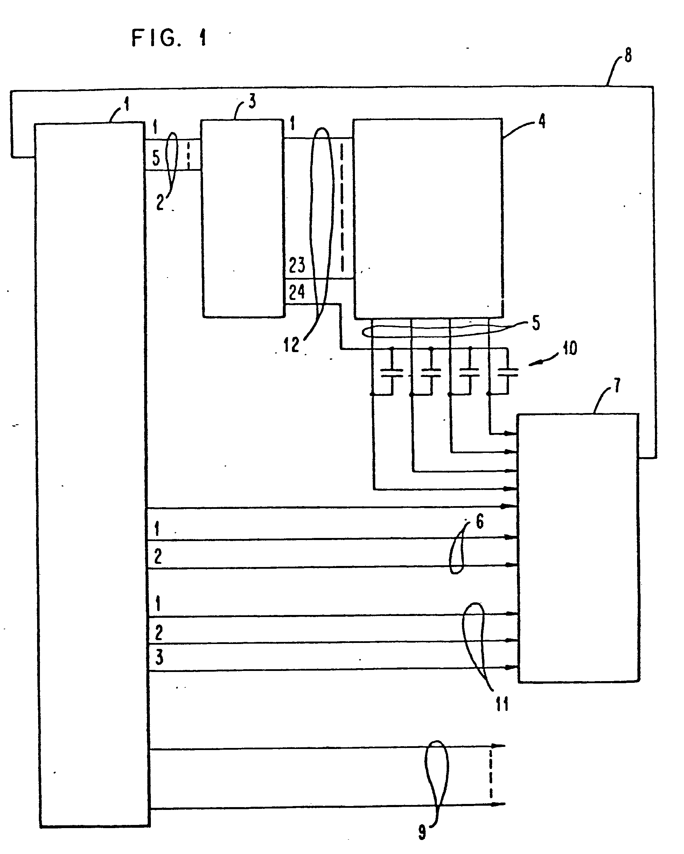

La Figure 1 représente le schéma de fonctionnement général d'un système de balayage de clavier à touches capacitives commandé par micro-calculateur, schéma qui met également en valeur la caractéristique d'établissement du seuil variable de la présente invention.

Les micro-calculateurs ou microprocesseurs mis en jeu dans les applications de commande d'interface de clavier programmable sont bien connus et sont disponibles dans le commerce. De nombreux fabricants peuvent proposer des claviers dont le fonctionnement s'appuie sur l'utilisation d'un microprocesseur monté sur une seule micro-plaquette pour traiter toute la logique de balayage de la matrice de touches et pour fournir la sortie codée lorsqu'une touche est détectée comme étant actionnée.

Comme cela est bien connu dans l'art antérieur, le micro-calculateur 1 est programmé pour exécuter, une routine de balayage de matrice d'un clavier qui est essentiellement un série d'instructions en boucle fermée qui sont exécutées en séquence. Le micro-calculateur 1 a une unité centrale de traitement de données, ou processeur, pour exécuter des instructions, une mémoire non volatile pour emmagasiner des instructions, une mémoire de données, qui peut être affaçable ou fixe, et diverses broches d'entrée et de sortie pour recevoir et fournir des signaux numériques, une source d'alimentation, etc..., de la façon bien connue. Un certain nombre des routines du microprocesseur peuvent être emmagasinées dans la mémoire non volatile en vue d'une exécution en réponse à des signaux appliqués de façon externe, comme cela est généralement le cas. Ces routines, formées de micro-instructions, comme cela est bien connu, sont des fonctions logiques qui peuvent être programmées suivant le besoin, une fois connus la série d'instructions et le format pour un micro-calculateur donné et une fois connues les sorties requises et la séquence logique interne du déroulement des opérations. Ces détails, qui sont bien connus dans l'art antérieur, ne seront pas décrits plus avant puisqu'ils ne font pas partie de la présente invention. Ils dépendent du micro-calculateur spécifique employé et sont évidents pour tout homme de l'art qui a pour tâche d'élaborer les fonctions de traitement de données et d'entrée/sortie requises une fois que ces fonctions lui sont précisées. Les sorties sont fournies sur diverses bornes de sortie et peuvent représenter, dans de nombreux cas, une série de comptes binaires variables. Par exemple, sur les lignes de sortie indiquées en 2, le micro-calculateur fournit 5 bits (ou éléments d'information binaires) qui sont décodés dans le multiplexeur 3 pour commander une ligne parmi les 24 lignes fournissant des impulsions de signal sur l'une quelconque des 24 rangées connectées dans une matrice de touches 4, à chacune des touches d'une rangée donnée. Les sorties sont fournies sur l'une quelconque des colonnes 5 qui font intersection avec les rangées lorsqu'une touche est enfoncée à une intersection donnée. Il est possible d'attaquer directement les rangées à partir du microprocesseur 1 à l'aide de signaux présents séparemment sur les différentes bornes de sortie si ces bornes de sortie sont en nombre suffisant. Dans ce cas, le multiplexage par décodage d'une adresse sur une ligne de sortie unique se fait de façon interne et est traité par une routine de microcodes à l'intérieur du microprocesseur. Le prix de construction du clavier est légèrement moins élevé dans ce cas puisque le multiplexeur 3 peut être éliminé. Dans ce dernier cas, les lignes de sortie utilisées à l'origine pour attaquer le multiplexeur seraient en plus grand nombre et directemment connectées aux rangées de la matrice 4. Ces deux modes de réalisation peuvent se comprendre à la lecture de la Figure 1. La dernière modification n'est pas décrite dans l'art antérieur et représente un élément nouveau. Bien entendu, la même modification est possible lors de l'attaque des portes de sélection ou de la fonction du décodeur en fournissant des sorties directes, dans la mesure où suffisamment de bornes sont disponibles sur le microprocesseur, pour les portes de sélection connectées aux colonnes et.

De façon générale, chaque colonne de sortie peut avoir son propre amplificateur à porte de commande ou, comme dans la présente réalisation elle peut être pourvue d'une porte de commande pour la connecter à un amplificateur de détection commun. L'acheminement des signaux d'une colonne donnée à un amplificateur de détection commun, se fait à l'aide du micro-calculateur 1 qui envoie sur les lignes 6 une adresse de conditionnement ou de sélection d'amplificateur de détection. Etant donné que le mode de réalisation ne montre que 4 colonnes, deux bits sont suffisants pour sélectionner l'une quelconque des 4 colonnes en appliquant l'adresse de sélection d'amplificateur de détection au circuit d'amplification à seuil variable 7 où les deux bits de la lignes 6 sont décodés pour conditionner une des colonnes 5 vers l'amplificateur de détection.

Lorsqu'un amplificateur de détection détecte qu'il y a production d'un signal de touche qui indique qu'une touche est enfoncée, une réaction sur la ligne 8 indique que la détection de la touche est envoyée dans le micro-calculateur 1 qui fournit alors sur sa sortie 9 un signal d'échantillonnage et de données au système d'utilisation, d'une manière bien connue dans l'art antérieur. Cette sortie de données peut être le compte binaire formé par les bits des lignes 2 et 6 et qui identifie uniquement une position donnée dans la matrice de touches capacitives 4, ou elle peut être codée dans une mémoire contenue dans le micro-calculateur 1 en un format quelconque requis. Ces caractéristiques, couramment utilisées dans l'art antérieur et qui ne font pas partie de la présente invention, ne sont pas décrites plus avant ice. En outre, la mémoire de données du microcalculateur 1 peut contenir d'autres informations associées à chaque touche de la matrice, à savoir, une adresse ou facteur de la valeur capacitive parasite, et des attributs logiques quelconques attribués à une touche, par exemple des fonctions typamatiques (des fonctions de répétitions automatique), des identifications de jeux de caractères ou des fonctions ayant une signification dans un système d'entrée de données.

La Figure 1 représente également d'autres éléments qui ne se retrouvent pas dans l'art antérieur. Plus précisément, les condensateurs de référence 10 sont représentés comme étant couplés entre une des lignes de sortie provenant du multiplexeur 3 et chacune des colonnes 5 à partir de la matrice de touches capacitives de manière à fournir des impulsions à un niveau de couplage capacitif référencé sur les entrées du circuit d'amplification 7. Bien que la figure représente plusieurs condensateurs de référence, dans la pratique, un seul peut être utilisé étant donné que les variations capacitives dans les colonnes ou rangées d'un clavier donné sont négligeables et que la sensibilité de l'amplificateur et les tolérances des composants, une fois prises en compte par un seul condensateur de référence, restent inchangées. Cependant, ce condensateur de référence est nécessaire étant donné que des modules ou microplaquettes de circuit sont employés pour construire les circuits et qu'il faut tenir compte des modifications d'une microplaquette à une autre. Le circuit d'attaque du condensateur de référence calibre effectivement à un niveau de détection acceptable les tolérances des composants qui vont, certes, différer d'un circuit à l'autre mais ne varier que légèrement dans un circuit donné. La séquence de calibrage décrite dans la suite doit être accomplie périodiquement pour tenir compte des variations de la source d'alimentation et des effets thermiques mais la séquence de recalibrage est arbitraire. Le ou les condensateurs de référence doivent être clibrés uniquement au départ et en suite à des périodes relativement peu fréquentes. Le recalibrage peut se faire à la fin de chaque séquence de balayage des touches ou bien chaque seconde ou chaque minute ou toutes les dix minutes, etc..., sous la commande du microprocesseur. Par ailleurs, comme cela est le cas dans la présente réalisation, la séquence de recalibrage peut se faire sur une base périodique régulière en l'intégrant à la séquence de balayage des touches.

Comme cela sera décrit dans la suite, et comme cela est mis en évidence du fait que la dernière sortie provenant du multiplexeur 3 est connectée au condensateur 10, chaque fois qu'une nouvelle colonne est sélectionné (c'est-àdire une fois qu'un compte complet a été engendré dans un cycle et une fois que la sortie finale provenant du multiplexeur 3 a été réalisée) le bit suivant dans le compete sélectionne une nouvelle adresse d'amplificateur de détection. Les bits d'amplificateur de détection sur les lignes 6 sont les deux bits d'ordre supérieur de l'adresse indiquant une position donnée de la matrice, et les bits d'ordre inférieur sont ceux des lignes 2.

Le seuil de l'amplificateur de détection est soumis à variation, conformément à la présente invention, sous la commande du micro-calculateur 1 jusqu'à ce qu'il n'y ait plus de sortie détectée une fois que les condensateurs de référence 10 ont reçu une impulsion provenant du multiplexeur 3. Le seuil de l'amplificateur de détection est commandé par une adresse de détection fournie sur les lignes 11 en provenance du micro-calculateur 1 est est reçu par le circuit d'amplification 7.

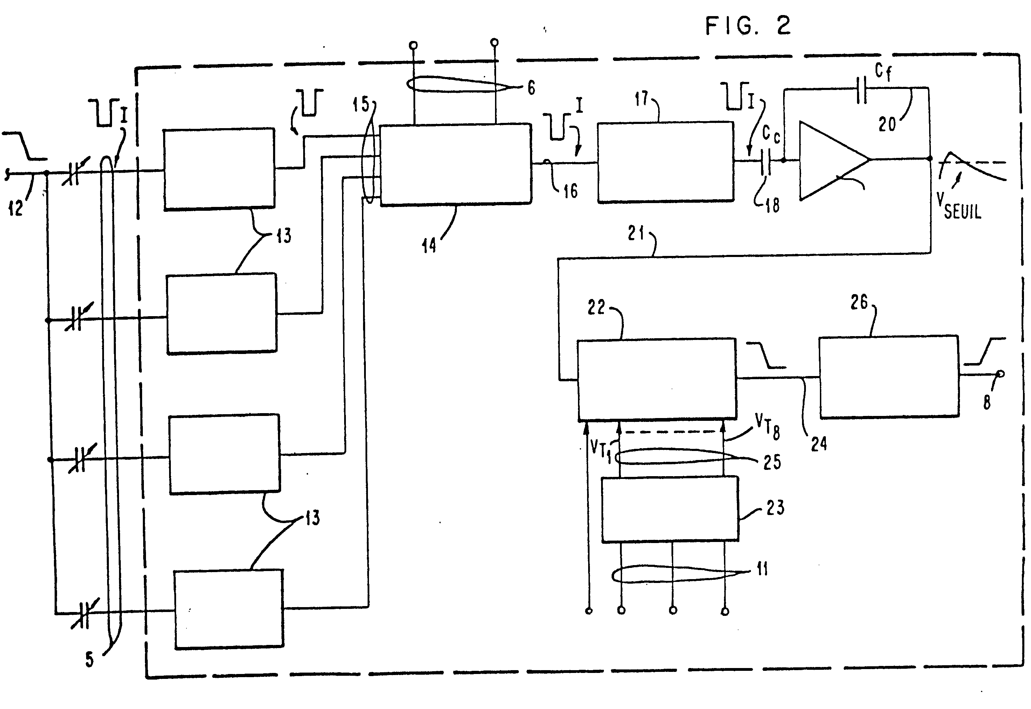

La Figure 2 représente schématiquement le contenu du circuit 7 de la Figure 1.

Sur la Figure 2, les impulsions d'attaque provenant du multiplexeur 3 sont envoyées sur une des lignes 12 au groupe comprenant les quatre condensateurs de touches d'une rangée donnée. Les lignes de sortie 5 sont connectées aux registres-tampons d'entrée 13 contenus dans le bloc logique 7. Les registres tampon 13 fournissent une interface de très faible impédance aux impulsions de courant apparaissant sur l'une quelconque des lignes 5 et ils envoient ces impulsions à l'entrée de la porte 14 de sélection d'amplificateur de détection qui décode l'adresse de sélection d'amplificateur de détection présents sur les lignes 6 afin de sélectionner et de conditionner uniquement une des quatre lignes d'entrée 15. La sortie provenant du décodeur 14 est envoyée sur la ligne 16 à un amplificateur de courant 17 qui amplifie l'impulsion de courant. Un condensateur de découplage en courant continu 18 envoie ensuite le signal provenant de l'amplificateur de courant 17 à un amplificateur d'intégration de courant 19 qui a un condensateur de couplage de réaction 20 de type bien connu dans l'art antérieur afin de fournir le signal de courant intégré. Cette opération produit un signal dont la forme est semblable à celle représentée schématiquement près de la ligne de sortie 21 qui effectivement remet en forme l'impulsion d'attaque en un signal en dents de scie. Cette impulsion est envoyée sur la ligne 21 en direction du circuit de sélection à seuil variable 22.

Le circuit de sélection 22 sélectionne un quelconque des huit niveaux, par exemple, sous la commande des lignes de sélection 25 provenant du décodeur 23. Le décodeur 23 reçoit les niveaux de sélection de seuil variable sur les lignes 11 en provenance du micro-calculateur 1, comme le montre la Figure 1. L'un quelconque des huit niveaux de sortie est sélectionné par le décodeur 23 conformément au compte binaire présent sur les lignes 11. Le circuit 22 règle ensuite le seuil à un niveau pré-établi. Lorsque le niveau de détection de seuil est atteint, une sortie 24 provenant du circuit 22 est envoyée à un circuit d'attaque de transistor 26 qui, comme le montre la Figure 1, envoie sur la ligne 8 le signal de détection qui indique qu'une position de touche a étet détectée comme étant actionnée. Un signal de restauration est envoyé par le microprocesseur 1, au départ ou à tout autre moment lorsqu'il apparaît nécessaire de restaurer le circuit 22.

Comme cela a été mentionné préalablement, le niveau de seuil effectif auquel est détectée la commutation, est représenté par la différence existant entre le seuil de l'amplificateur de détection et la valeur de la capacité de couplage parasite qui existe pour une position de touche donnée. C'est-à-dire, pour un seuil de sensibilité donnée de l'amplificateur de détection, une portion du signal d'entrée est continuement présente par suite de la capacité parasite, et seule une petite portion supplémentaire, égale à la différence existant entre le seuil et le signal d'entrée dû à la capacité parasite, est nécessaire en faisant varier la capacité à la position de la touche.

Le tableau 1 donné ci-après indique le seuil de sensibilité effectif exprimé en picofarads (et non pas en volts ou en ampères), étant bien compris que la sensibilité d'entrée est un seuil de tension qui serait obtenu en faisant varier un signal d'entrée au moyen d'une capacité mesurée en picofarads.

TABLEAU 1
Seuil effectif

|  |  | Gamme de sensibilité (en picofarads) | | | | |
|---|---|---|---|---|---|---|
|  |  | 0,8 | 0,9 | 1,0 | 1,1 | 1,2 |
| Capacité parasite (en picofarads) | 0,5 | 0,3 | 0,4 | 0,5 | 0,6 | 0,7 |
|  | 0,4 | 0,4 | 0,5 | 0,6 | 0,7 | 0,8 |
|  | 0,3 | 0,5 | 0,6 | 0,7 | 0,8 | 0,9 |
|  | 0,2 | 0,6 | 0,7 | 0,8 | 0,9 | 1,0 |

Le tableau 1 illustre le seuil de sensibilité, exprimé en picofarads, en fonction de la capacité parasite, exprimé en picofards, et représente le seuil effectif comme étant la différence, exprimée en picofards, existant entre ces deux valeurs. On peut observer que, pour une sensibilité d'entrée nominale dans la gamme de 1 picofarad, la capacité parasite se trouve entre 0,2—0,5 picofarads et le seuil de sensibilité effectif peut varier en conséquence de 0,5 à 0,8 picofarad. Ceci signifie que, pour un niveau de capacité parasite de 0,5 picofarad, seul un changement de 0,5 picofarad est nécessaire à la position de la touche pour atteindre le seuil de sensibilité de l'amplificateur de détection s'il est fixé à 1 picofarad. En conséquence, de légers déplacements, la présence d'agents de contamination sur les plaques capacitives ou des variations de la source d'alimentation peuvent provoquer une détection erronée de l'enfoncement de la touche. A l'autre extrémité de l'echelle, si on a une capacité de couplage parasite qui ne dépasse pas 0,2 picofarad, il peut être nécessaire de produire un changement de 0,8 picofarad à la position de la touche de manière à créer un signal de niveau suffisamment élevé pour être détecté. Dans la pratique, ce dernier cas peut ne pas être réalisé pour certaines touches. Le résultat est que la détection de la position de la touche n'est pas possible au niveau donné de la sensibilité d'entrée de l'amplificateur.

Le tableau 2 illustre les adresses binaires en fonction des seuils de sensibilité de l'amplificateur de détection à seuil variable exprimés en picofarads. Le décodeur 23 de la Figure 2 répond aux adresses d'entrée binaires représentées sur le tableau 2 afin de sélectionner un des huit niveaux de sensibilité du seuil de sortie dans le circuit de seuil variable 22 dont les valeurs sont illustrées sur le tableau. Un condensateur de référence d'entrée de 1 picofarad 10 peut être effectivement détecté avece une gamme de seuils de sensibilité d'entrée allant de 0,8 à 1,2 picofarads, comme le met en évidence le tableau. L'importance de cette gamme de valeurs sera mise en évidence das la suite.

TABLEAU 2
Adresse en fonction de seuil de sensibilité
de l'amplificateur

| Adresse | Seuil | | |
|---|---|---|---|
| 000 | 0,6±0,2 pF | | |
| 001 | 0,7 | " | |
| 010 | 0,8 | " | Gamme des adresses pour |
| 011 | 0,9 | " | un condensateur de |
| 100 | 1,0 | " | référence de 1 pF. |
| 101 | 1,1 | " | |
| 110 | 1,2 | " | |
| 111 | 1,3 | " | |

Comme cela a été mentionné préalablement, pour compenser les effets des niveaux de détection variables dus aux tolérances des composants, à la variation de la source d'alimentation, etc..., un condensateur de référence 10 est placé à l'entrée l'amplificateur de détection et, bien qu'il suffise d'une fréquence de recalibrage arbitraire quelconque, ce condensateur reçoit des signaux d'attaque provenant d'une ligne d'attaque commune 12 chaque fois qu'est transmise une nouvelle combinaison de bits sur les lignes 6. Ces bits sont impliqués chaque fois que les bits d'ordre inférieur sur les lignes 2, atteignent leur compte maximum et qu'une sortie est appliquée sur la ligne 12 en direction des condensateurs de référence 10, comme le montre la Figure 1.

Une impulsion de signal d'attaque est appliquée par un circuit d'attaque commun sur la ligne 12 à tous les condensateurs de référence et, en même temps, le seuil sélectionné pour l'amplificateur de détection est augmenté en modifiant le compte des lignes 11 jusqu'à ce que plus aucune sortie de signal ne soit détectée sur la ligne 8. A ce stade, le système de détection de touche est calibré à une variation, ou niveau de commutation, de 1 picofarad en supposant que des condensateurs de référence de 1 picofarad soient utilisés comme condensateurs 10. De cette manière, chaque fois qu'une nouvelle colonne est sélectionnée, les conditions de source d'alimentation, tension d'attaque, sensibilité d'amplificateur de détection et de tolérances des composants, sont toutes recalibrées, réajustées ou compensées en établissant le niveau de détection de l'amplificateur, pour les conditions existantes, à un seuil supérieur à celui correspondant à un changement de capacité de 1 picofarad sur la ligne d'entrée. En outre, une gamme de valeurs de la capacitié parasite est associée au type spécifique de l'agencement de la matrice capacitive, concernant par exemple, le nombre, la dimension des touches et leur position entre elles. La capacité parasite varie de façon importante d'une touche à l'autre mais ne varie pas de façon importante d'un clavier à l'autre pourvu que soit employé le même agencement physique. En conséquence, les valeurs de la capacité parasite associées aux positions de touche d'une matrice capacitive sont emmagasinées dans une mèmoire permanente incorporée dans le micro-calculateur. Le tableau 3 ci-dessous montre une gamme typique des valeurs de la capacité parasite qui sont données en fonction des facteurs de présence d'une capacité parasite sur les touches.

TABLEAU 3
Facteurs de présence d'une capacitié parasite
sur les touches

| Capacité parasite | Facteur |
|---|---|
| 0,5 pF | +001 |
| 0,4 pF | 000 |
| 0,3 pF | —001 |
| 0,2 pF | —010 |

On a normalement une capacité parasite nominale de 0,4 picofarad et, dans l'exemple illustré, aucun réglage n'est fait chaque fois qu'il existe une capacité parasite de 0,4 picofarad. Ce cas sera décrit de façon plus détaillée dans la suite.

Les facteurs d'adresses associées aux valeurs en picofarads de la capacité parasite du tableau 3, sont utilisés dans le micro-calculateur 1 pour perfectionner le réglage du seuil de sensibilité qui a été réglé au niveau de calibrage du condensateur de référence, comme cela a été décrit préalablement. Si, à une position de touche donnée, il apparaît une capacité parasite supérieure à la normale, l'adresse sur les lignes de sélection de seuil de l'amplificateur de détection 11, est augmentée d'une unité afin de diminuer la sensibilité de l'amplificateur (c'est-à-dire élever son seuil de sensibilité) et les cas opposé est obtenu lorsqu'il existe une capacité parasité inférieure á la capacitié parasite nominale de 0,4 picofarad en diminuant le compte binaire des lignes 11, comme le montrent les valeurs du tableau 3.

A l'aide des procédés qui viennent d'être décrits, toutes variations au clavier peuvent être compensées et le seuil de détection effectif est de 0,6 picofarad seuil qui représente le niveau de calibrage nominal de 1 picofarad moins le niveau de la capacité parasite nominale de 0,4 picofarad. Dans un mode de réalisation préféré s'appliquant à toutes les touches du clavier, ce seuil offre un espacement libre de 0,02 cm entre la plaque de couplage mobile et la plaque de couplage fixe.

On va maintenant décrire le fonctionnement du calculateur pour calibrer et ensuite regler le seuil de l'amplificateur de détection. Au départ, on procède à une remise sous tension, opération qui est suivie par une incrémentation de l'adresse de sélection de seuil d'amplificateur de détection pour fixer le seuil de l'amplificateur de détection à la valeur atteinte par le compte binaire 000. Comme le montre le tableau 2, cette opération fixe effectivement le seuil d'entrée à un niveau de sensibilité nominale de 0,6 picofarad pour une capacité de référence de 1 picofarad à son entrée. Ensuite, les condensateurs de référence reçoivent un signal d'attaque en envoyant le compte sur les lignes 5 à partir du micro-calculateur 1 de la Figure 1, signal qui, lorsqu'il est décodé par le multiplexeur 3, est transmis sur la dernière ligne qui est connectée au condensateur de référence 10, comme le montre la figure. Si une réaction qui indique que l'amplificateur de détection détecte un signal, est appliquée sur la ligne 8, le micro-calculateur détermine que l'amplificateur de détection est "fermé". Dans le cas où l'amplificateur de détection est détecté comme étant "fermé", le seuil de l'amplificateur de détection est emmagasiné dans un registre d'emmagasinage du micro-calculateur 1, et le facteur de capacité parasite correspondant à l'adresse associée à la première touche à balayer, est extrait de la mémoire et est ajouté dans un registre de travail à la valeur provenant du registre d'emmagasinage. Le résultat représente le nouveau niveau de seuil de l'amplificateur de détection. Ensuite, la capacité de la touche est attaquée durant le cycle de balayage qui lui est appliqué. Si la touche apparaît comme étant la dernière touche qui est connectée à un amplificateur de détection donnée, il y a décision d'incrémentation de l'adresse de sélection de l'amplificateur de détection, mais si la touche n'est pas la dernière touche connectée à un amplificateur donné, l'adresse de la touche est incrémentée et la valeur de la capacité parasite de l'adresse de la touche est extraite et ajoutée au niveau de seuil de l'amplificateur de détection jusqu'à ce qu'il y ait eu balayage de toutes les touches associées à un amplificateur de détection donné.

Lorsque la dernière touche connectee à un amplificateur de détection donné a été détectée, l'adresse de l'amplificateur de détection est modifiée pour sélectionner un nouvel amplificateur de détection et il y a remise en route de la routine de calibrage de l'amplificateur de détection utilisée pour attaquer la capacité de référence, comme cela a été décrit préalablement. Dans une routine de calibrage quelconque, si l'amplificateur de détection indique qu'il détecte un signal d'entrée, l'adresse de seuil de l'amplificateur de détection est incrémentée de 1. Puis, il y a comparaison pour déterminer si l'adresse de seuil maximal de l'amplificateur de détection a été atteinte. Dans l'affirmative, il y a indication d'une erreur de réglage. Dans la négative, les condensateurs de référence sont attaqués à nouveau afin de déterminer si oui ou non la condition d'amplificateur de détection fermé a été réalisée. Lorsque cette condition a été réalisée, le niveau de seuil de l'adresse est emmagasiné et il y a remise en route de la routine de balayage des touches, comme cela a été décrit préalablement.

Les étapes spécifiques du programme à écrire sous forme d'instructions de microcode d'un micro-calculateur pour exécuter la routine sont évidentes pour l'homme de l'art. En outre, vu que les instructions de code spécifiques d'un micro-calculateur donné dépendent des facilités, de la conception et du fonctionnement du micro-calculateur proposé, elles ne font pas partie de la présente invention.

La routine de balayage décrite préalablement fonctionne pour balayer toutes les rangées faisant intersection avec u: colonne donnée alors conditionnée par une des portes de sélection de l'amplificateur. L'opération in: erse est égalemnt possible, opération dans laquelle chacune des portes est sélectionnée en séquence avant que ne soit produit un nouveau signal d'attaque de rangée. C'est-à-dire, le balayage peut se faire en balayant toutes les rangées qui font intersecttion avec une colonne ou bien en balayant toutes les colonnes qui font intersection avec une rangée. Dans le mode de réalisation préféré de la présente invention, étant donné qu'il y a un condensateur par colonne, tous les condensateurs étant connectés à une rangée, il est plus facile de procéder à un calibrage sur le condensateur de référence d'une colonne et ensuite de balayer séquentiellement toutes les rangées qui lui font intersection en appliquant les codes appropriés au multiplexeur 3. Il est également possible, comme cela a été mentionné préalablement d'appliquer directement des impulsions d'attaque provenant des points de sortie du microprocesseur 1 et d'éliminer entièrement le multiplexeur 3.

La logique de programmation à laquelle fait appel le micro-calculateur pour établir la routine d'établissement de la sensibilité variable va maintenant être décrit. L'opération de démarrage engendre une fonction de restauration de tous les registres, fonction qui est connue comme fonction d'amorçage ou de remise sous tension couramment employée dans les machines programmées. Le registre d'adresses de sélection d'amplificateur de détection est laors incrémenté et le seuil de l'amplificateur de détection est fixé à OOO. Ceci correspond à un seuil de 0,6±0,2 picofarad. Les condensateurs de référence sont ensuite attaqués en fournissant une sortie sur la ligne d'attaque de condesateur de référence, la dernière sortie provenant du multiplexeur 3, comme le montre la Figure 1. On procède ensuite à un test pour déterminer si le circuit d'amplification 7 a détecté une impulsion. Dans l'affirmative, il n'a pas détecté la fermeture du commutateur d'une touche dans laquelle est transmise très peu d'énergie. Si en revanche, l'amplificateur de détection a détecté la fermeture d'une touche (ou plus exactement la fermeture du commutateur d'une touche qui correspond à l'ouverture des plaques de couplage capacitif), le seuil de l'amplificateur de détection est incrémenté de 1 et on procède à une vérification pour savoir si le seuil maximal a été atteint. Si le seuil maximal n'a pas été atteint, le condensateur de référence est à nouveau attaqué et on procède à une vérification pour déterminer si l'amplificateur de détection a détecté une touche comme étant fermée. La routine se poursuit jusqu'à ce que finalement l'amplificateur de détection détecte ce qu'il interprète comme une fermeture de touche et il y a emmagasinage de l'adresse de seuil de l'amplificateur de détection alors existante. La routine recherche ensuite les facteurs de la capacité parasite des touches d'un clavier dont l'agencement des touches est donnée. Ces facteurs, comme cela a été noté prélablement, varient considérablement pour une position de touche donnée et non pas pour l'ensemble des touches si bien que ces facteurs peuvent être programmés pour une configuration donnée de touches d'un clavier dont l'agencement est typique. Lorsque cette opération est réalisée, l'instruction est alors exécutée pour attaquer le signal de capacité de touche afin de procéder à un cycle de balayage de touches. Il y a vérification pour déterminer si la touche dernièrement balayée est la dernière touche connectée à un amplificateur de détection donné. Si c'est la dernière touche, il y a alors introduction d'une nouvelle boucle d'instructions d'exécution afin d'incrémenter l'opération d'établissement de seuil avant de poursuivre le balayage. Si la touche n'est pas la dernière touche connectée à un amplificateur de détection donné, l'adresse de touche est alors incrémentée et les facteurs de capacité parasite de touche sont recherchés pour cette touche, et un autre cycle d'attaque et de balayage est introduit.

Il y a indication d'une condition d'erreur ou "hors limites" dans le cas où le seuil de l'amplificateur de détection atteint le maximum sans détecter une fermeture de touche durant l'opération de fixation du seuil de référence, décrite préalablement.

Un cycle complet d'instructions pour un microprocesseur quelconque peut facilement être conçu par l'homme de l'art à partir des manuels de référence et des instructions spécifiques à un microcalculateur donné. Il s'ensuit qu'il n'est donné ici aucune liste détaillée des instructions de microprogramme. Les instructions et le programme spécifique représentant le meilleur mode de réalisation de la routine de test et d'établissement du seuil employé dans le mode de balayage de la présente invention, sont indépendants des micro-instructions spécifiques qui peuvent être nécessaires à un microprocesseur donné pour qu'il puisse exécuter la routine. La liste des instructions de microcode est facilement disponible puisqu'elle accompagne les machines disponibles dans le commerce.

Dans la description du mode de réalisation de la présente invention, il est évident pour l'homme de l'art que d'autres routines de micro-programmes pour tester et établir le seuil d'un amplificateur de détection d'une façon sensible au résultat d'un test de sensibilité sur une position de touche ou s. l'amplificateur de détection, peuvent être facilement conçues. Par exemple, on peut facilemen: envisager des modes de réalisation à processeurs multiples et à plus grande vitesse dans lesquels une fonction d'une partie du microprocesseur consisterait à tester et à établir le seuil de la sensibilité de l'amplificateur de détection tandis qu'une autre partie d'un autre microprocesseur aurait comme fonction de conduire une routine de balayage pour détecter des touches fermées en utilisant les valeurs provenant d'un seuil préalablement fixé à partir d'une exécution précédente dans la première section du microprocesseur. En outre, bien que la présente invention ait été décrite en référence à un clavier ayant une matrice de touches capacitives, d'autres impedances variables, par exemple des résistances et des inductances, peuvent être employées de façon semblable pour obtenir le même effet. Des condensateurs ont été choisis dans le mode de réalisation préféré car les problèmes de bruits sont moins

O 023 271

nombreux et ces condensateurs sont moins coûteux et plus faciles à fabriquer que des résistances ou des inductances.

## Revendications

1. Clavier d'entrée de données comprenant une matrice de touches à impédance variable (4) correspondant respectivement aux intersections de rangées d'entrée (12) et de colonnes de sortie (5), un microprocesseur programmé (1) ayant au moins une entrée de signal (8) et plusieurs sorties de signal, ledit microprocesseur (1) commandant l'application de signaux d'attaque sur chacune desdites rangées et étant programmé pour balayer séquentiellement les intersections de ladite matrice et fournir des signaux sur les colonnes de sortie de façon à déterminer si l'une quelconque des touches a changé d'état; ledit clavier étant caractérisé en ce que:

une impédance de référence fixe (10) est placée à au moins une intersection de ladite matrice à laquelle n'est pas associée une touche à impédance variable pour connecter la rangée et la colonne se trouvant à ladite intersection,

un circuit d'amplification à seuil variable (7) est connecté à chacune des colonnes de sortie de ladite matrice et a pour fonction d'amplifier les signaux reçus sur la colonne de sortie correspondante qui dépassent un seuil déterminé, la sortie dudit circuit d'amplification étant connectée à l'entrée dudit microprocesseur afin de fourni une indication qu'un signal dépassant ledit seuil a été détecté et amplifié par ledit circuit d'amplification,

ledit microprocesseur est programmé pour d'une part fournir au moins une fois un signal d'attaque à ladite impédance de référence et pour fournir à nouveau un signal d'attaque à ladite impédance de référence chaque fois qu'un signal en réponse audit signal d'attaque de l'impédance de référence est reçu à l'entrée dudit microprocesseur à partir de ladite sortie dudit circuit d'amplification, et d'autre part pour fournir en sortie des signaux de seuil audit circuit d'amplification à seuil variable pour initialement établir ledit seuil à son minimum puis élever ledit seuil selon une gamme de niveaux croissants à chaque fois qu'un signal d'attaque de l'impédance de référence a donné lieu à un signal de réponse reçu à l'entrée dudit microprocesseur, de manière à déterminer un signal de seuil de base pour ledit circuit d'amplification, et

ledit microprocesseur comprend une mémoire de données dans laquelle est emmagasiné un facteur d'impédance parasite associé à chaque position de touche identifiée à l'intersection d'une rangée et d'une colonne, ledit microprocesseur étant programmé pour avoir accès à l'emplacement de ladite mémoire de données associé à chacune des touches chaque fois que l'intersection correspondante de la matrice est balayée, de manière à modifier ledit signal de seuil de base en fonction dudit facteur d'impédance parasite associé à ladite touche et neutraliser ainsi les effets dûs à l'impédance parasite de ladite touche lors de son enfoncement.

2. Clavier selon la revendication 1 caractérisé en ce que ledit circuit d'amplification (7) comporte plusieurs entrées d'adresses (11) et des moyens (23, 22) pour modifier ledit seuil en réponse à la réception d'une adresse d'établissement de seuil reçue auxdites entrées d'adresse.

3. Clavier selon la revendication 2 caractérisé en ce que ledit microprocesseur (1) est programmé pour emmagasiner l'adresse d'etablissement de seuil dernièrement fournie et, à chaque balayage de chaque touche pour ajouter à ladite adresse ledit facteur d'impédance parasite provenant de ladite mémoire de données associée à ladite touche afin de fournir une nouvelle adresse d'établissement de seuil pour chaque touche au moment où ladite touche reçoit un signal de balayage.

4. Clavier selon l'une quelconque des revendications précédentes, caractérisé en ce qu'une impédance de référence (10) est connectée à chaque intersection d'une desdites rangées d'entrée (12) et chacune desdites colonnes de sortie (5) et en ce que ledit microprocesseur (1) est programmé pour, en réponse à la sélection d'une colonne de sortie en provenance de ladite matrice de touches (4), fournir un signal d'attaque à l'impédance de référence associée.

5. Clavier selon la revendication 4, caractérisé en ce qu'une seule impédance de référence (10) est connectée entre ladite rangée d'entrée (12) et une desdites colonnes de sortie (5).

6. Clavier selon l'une quelconque des revendications précédentes, caractérisé en ce que les touches de ladite matrice sont des touches capacitives.

7. Clavier selon l'une quelconque des revendications précédentes caractérisé en ce qu'un dispositif de multiplexage (3) est connecté entre ledit microprocesseur (1) et ladite matrice (4) pour fournir les signaux d'attaque sur les rangées de ladite matrice en réponse à des signaux codés fournis par ledit microprocesseur.

## Patentansprüche

1. Tastatur für die Dateneingabe, bestehend aus matrixartig an den Schnittpunkten von Eingabereihen (12) und von Ausgangsspalten (5) angeordneten Tasten mit veränderlicher Impedanz (4), einem programmierten Mikroprozessor (1) mit mindestens einem Signaleingang (8) und mehreren Signalausgängen, wobei der Mikroprozessor (1) das Anlegen der Ansteuerungssignale an jede der genannten Reihen steuert und so programmiert ist, um sequentiell die Schnittpunkte der genannten Matrix abzutasten und Signale an die Ausgangsspalten zu liefern zur Ermittlung, ob eine der Tasten ihren Zustand verändert hat, dadurch gekennzeichnet, daß

eine feste Bezugsimpedanz (10) an mindestens einem der Schnittpunkte der genannten Matrix angeordnet ist, der eine Taste mit veränderlicher Impedanz zugeordnet ist, um die Reihe und die Spalte am genannten Schnittpunkt zu verknüpfen,

eine Verstärkerschaltung mit veränderlicher Schwelle (7) an jeder der Ausgangsspalten der genannten Matrix angeschlossen ist, die die Aufgabe hat, die an der entsprechenden Ausgangsspalte empfangenen Signale, die eine bestimmte Schwelle übersteigen, zu verstärken, wobei der Ausgang der genannten Verstärkerschaltung an den Eingang des genannten Mikroprozessors gelegt wird, um eine Angabe zu liefern, daß ein die genannte Schwelle überschreitendes Signal detektiert und von der genannten Verstärkerschaltung verstärkt würde,

der genannte Mikroprozessor so programmiert ist, daß er einerseits der genannten Bezugsimpedanz mindestens einmal ein Ansteuerungssignal liefert und daß er dieser Bezugsimpedanz jedesmal, wenn ein Signal als Antwort auf das genannte Ansteuerungssignal der Bezugsimpedanz am Eingang des genannten Mikroprozessors vom genannten Ausgang der genannten Verstärkerschaltung empfangen wird, erneut ein Ansteuerungssignal liefert, und daß er andrerseits am Ausgang Schwellensignale an die genannte Verstärkerschaltung mit veränderlicher Schwelle abgibt, um die genannte Schwelle anfangs auf ihrem Mindestwert zu halten und sie dann in einer Reihe von Schritten anzuheben, jedesmal wenn ein Ansteuerungssignal der Bezugsimpedanz ein Antwortsignal ausgelöst hat, das am Eingang des genannten Mikroprozessors empfangen wurde, um ein Ausgangsschwellensignal für die genannte Verstärkerschaltung zu bestimmen, und

daß der genannte Mikroprozessor einen Datenspeicher enthält, in dem ein jeder Tastenfunktion zugeordneter Störimpedanzfaktor gespeichert ist, wobei eine Taste durch den Schnittpunkt einer Zeile und einer Spalte identifiziert ist.

und daß dieser Mikroprozessor programmiert ist, um Zugang zu der jeder Taste zugeordneten Stelle des genannten Datenspeichers zu erhalten, wenn der entsprechende Schnittpunkt der Matrix abgetastet wird, so daß das Ausgangsschwellensignal in Abhängigkeit von dem der jeweiligen Taste zugeordneten genannten Störimpedanzfaktor geändert wird und daß die durch die Störimpedanz bedingten Auswirkungen des Eindrückens der Taste aufgehoben werden.

2. Tastatur nach Anspruch 1, dadurch gekennzeichnet, daß die genannte Verstärkerschaltung (7) mehrere Adresseneingänge (11) hat und Mittel (23, 22) enthält, um die genannte Schwelle je nach dem Empfang einer Adresse für die Errichtung einer Schwelle an den genannten Adreßeingängen zu ändern.

3. Tastatur nach Anspruch 2, dadurch gekennzeichnet, daß der genannte Mikroprozessor (1) dafür programmiert ist, die zuletzt gelieferte Adresse für die Errichtung einer Schwelle zu speichern und beim Abtasten einer jeden Taste der gekennten Adresse den genannten Störimpedanzfaktor hinzuzuaddieren, der vom genannten Datenspeicher kommt, in Verbindung mit der genannten Taste, um eine neue Adresse für die Errichtung einer Schwelle zu liefern, wenn die genannte Taste einen Abtastimpuls empfängt.

4. Tastatur nach einem der vorangehenden Ansprüche, dadurch gekennzeichnet, daß jedem Schnittpunkt einer der genannten Eingangsreihen (12) mit einer der genannten Ausgangsspalten (5) eine Bezugsimpedanz (10) zugeordnet ist, und daß der genannte Mikroprozessor (1) so programmiert ist, daß er als Antwort auf die Wahl einer Ausgangsspalte von der genannten Tastenmatrix (4) ein Ansteuerungssignal an die zugeordnete Bezugsimpedanz abgibt.

5. Tastatur nach Anspruch 4, dadurch gekennzeichnet, daß nur eine Bezugsimpedanz (10) zwischen der genannten Eingangsimpedanz (12) und einer jeden der genannten Ausgangsspalten (5) angeschlossen ist.

6. Tastatur nach einem der vorangehenden Ansprüche, dadurch gekennzeichnet, daß die Tasten der genannten Matrix kapazitive Tasten sind.

7. Tastatur nach einem der vorangehenden Ansprüche, dadurch gekennzeichnet, daß eine Multiplexvorrichtung (3) zwischen dem genannten Mikroprozessor (1) und der genannten Matrix (4) geschaltet ist, um die Ansteuerungssignale an die Reihen der genannten Matrix in Antwort auf die vom genannten Mikroprozessor abgegebenen codierten Signale zu liefern.

**Claims**

1. A data input keyboard including an array of variable-impedance keys (4), corresponding respectively to the intersections of the input rows (12) and the output columns (5); a programmed microprocessor (1) having at least one signal input (8) and a plurality of signal outputs, said microprocessor (1) controlling the application of drive signals to each of the said rows and being programmed to sequentially sweep the intersections of said array and supply the signals on the output columns so as to determine whether any one of the keys has its state changed; said keyboard being characterized in that:

a fixed reference impedance (10) is placed at at least one intersection of said array, to which is not associated a variable impedance key to connect the row and the column located at said intersection,

A variable threshold amplification circuit (7) is connected to each of the output columns of the said array and serves to amplify the signals received on the corresponding output column that exceed the determined threshold value, the output of said amplification circuit being connected to the input of said microprocessor, so as to supply an indication that a signal exceeding said threshold has been detected and amplified by said amplification circuit,

said microprocessor is programmed so as to supply at least once a drive signal to said reference impedance and to again supply a drive signal to said reference impedance each time a signal in response to said drive signal to the reference impedance is received at the input of said microprocessor from said output of said amplification circuit, and to supply at the output the threshold signals to said variable-threshold amplification circuit to initially establish said threshold at its minimum value, then to raise the said threshold in accordance with an increasing range of levels each time a drive signal into the reference impedance has given rise to a response signal received at the input of said microprocessor, in order to determine a basic threshold signal for the said amplification circuit, and

said microprocessor includes a data memory, in which is stored a spurious impedance factor associated with each key position identified at the intersection of a row and a column, said microprocessor being programmed to have access to the location in said data memory associated with each of the keys each time the corresponding intersection of the array is swept, so as to modify said basic threshold signal as a function of said spurious impedance factor associated with said key and thus neutralize the effects due to the spurious impedance of said key when it is depressed.

2. Keyboard in accordance with claim 1, characterized in that said amplification circuit (7) includes several address inputs (11) and means (23, 22) to modify said threshold in response to the reception of a threshold-setting address received at said address inputs.

3. Keyboard in accordance with claim 2, characterized in that said microprocessor (1) is programmed to store the threshold-setting address last supplied, and, at each sweeping of each key, to add to said address said spurious impedance factor coming from said data memory associated with said key, in order to supply a new threshold-setting address for each key at the instant that said key receives a sweep signal.

4. Keyboard in accordance with any of the above claims, characterized in that a reference impedance (10) is connected to each intersection of said input rows (12) and each of said output columns (5) and in that said microprocessor (1) is programmed to, in response to the selection of an output column from said array of keys (4), supply a drive signal to the associated reference impedance.

5. Keyboard in accordance with claim 4, characterized in that only one reference impedance (10) is connected between said input row (12) and one of said output columns (5).

6. Keyboard in accordance with any of the above claims, characterized in that the keys of said array are capacitive.

7. Keyboard in accordance with any of the above claims, characterized in that a multiplexing device (3) is connected between said microprocessor (1) and said array (4) to supply the drive signals to the rows of said array in response to coded signals supplied by said microprocessor.

FIG. 1

FIG. 2